# EUROPÄISCHE PATENTSCHRIFT

(11) **EP 4 144 480 B1**
(45) Veröffentlichungstag und Bekanntmachung des Hinweises auf die Patenterteilung: **31.01.2024**
(21) Anmeldenummer: 21194262.8
(22) Anmeldetag: 01.09.2021
(51) Int. Cl.: B24B 1/00, B24B 7/22, B24B 55/02, B24B 37/08, B24B 7/17, B24D 7/06, B24B 37/04

(54) **VERFAHREN ZUM SCHLEIFEN VON HALBLEITERSCHEIBEN**
METHOD OF GRINDING SEMICONDUCTOR WAFERS
PROCÉDÉ DE PONÇAGE DE TRANCHES

(43) Veröffentlichungstag der Anmeldung: 08.03.2023
(73) Patentinhaber: Siltronic AG, 81677 München (DE)
(72) Erfinder: Oberhans, Stephan, 83119 Obing (DE); Kerstan, Michael, 84486 Burghausen (DE); Weiß, Robert, 84543 Winhöring (DE)
(74) Vertreter: Killinger, Andreas

(56) Entgegenhaltungen:
- DE-A1-102007 030 958
- DE-A1-102017 215 705
- KR-A- 20110 066 282

## Beschreibung

Gegenstand der vorliegenden Erfindung ist ein Verfahren zum Schleifen einer Scheibe aus Halbleitermaterial. Die Erfindung basiert auf der optimalen Verteilung einer Flüssigkeit im Umfeld des Schleifwerkzeugs zur gleichzeitig beidseitigen Material abtragenden Bearbeitung einer Halbleiterscheibe.

Für Elektronik, Mikroelektronik und Mikro-Elektromechanik werden als Ausgangsmaterialien Halbleiterscheiben (Substrate) mit extremen Anforderungen an globale und lokale Ebenheit, einseitig bezogene lokale Ebenheit (Nanotopologie), Rauigkeit und Sauberkeit benötigt. Halbleiterscheiben sind Scheiben aus Halbleitermaterialien, insbesondere Verbindungshalbleiter wie Galliumarsenid oder Elementhalbleiter wie Silizium und Germanium.

Gemäß dem Stand der Technik werden Halbleiterscheiben in einer Vielzahl von aufeinander folgenden Prozessschritten hergestellt. Im Allgemeinen wird folgende Herstellungssequenz benutzt:
- 1: - Herstellen eines einkristallinen Halbleiterstabs (Kristallzucht),
- 2: - Zerteilen des Halbleiterstabs in einzelne Stabstücke,
- 3: - Auftrennen des Stabs in einzelne Scheiben (Innenloch- oder Drahtsägen),
- 4: - mechanische Bearbeitung der Scheiben (Läppen, Schleifen),
- 5: - chemische Bearbeitung der Scheiben (alkalische oder saure Ätze),
- 6: - chemo-mechanische Bearbeitung der Scheiben (Politur),
- 7: - optional weitere Beschichtungsschritte (z.B. Epitaxie, Temperaturbehandlung)

Die mechanische Bearbeitung der Halbleiterscheibe dient der Entfernung von Sägewelligkeiten, ferner dem Abtrag der durch die raueren Sägeprozesse kristallin geschädigten oder vom Sägedraht kontaminierten Oberflächenschichten und vor allem der globalen Einebnung der Halbleiterscheiben. Ferner dient die mechanische Bearbeitung der Halbleiterscheibe der Herstellung einer gleichmäßigen Dickenverteilung, d.h. dass die Halbleiterscheiben eine gleichmäßige Dicke haben.

Als Verfahren zur mechanischen Bearbeitung der Halbleiterscheiben sind das Läppen sowie das Oberflächenschleifen (einseitig, doppelseitig) bekannt.

### Die Technik des doppelseitigen Läppens von gleichzeitig mehreren

Halbleiterscheiben ist seit langem bekannt und beispielsweise in der EP 547894 A1 beschrieben. Beim doppelseitigen Läppen werden die Halbleiterscheiben unter Zuführung einer einen Abrasivstoff enthaltenden Suspension zwischen einer oberen und einer unteren Arbeitsscheibe, die meist aus Stahl bestehen und mit Kanälen zur besseren Verteilung der Suspension versehenen sind, unter einem gewissen Druck bewegt und dadurch ein Materialabtrag bewirkt. Die Halbleiterscheibe wird durch eine Läuferscheibe ("carrier") mit Aussparungen zur Aufnahme der Halbleiterscheiben während des Läppens geführt, wobei die Halbleiterscheibe durch die mittels Antriebskränze in Rotation versetzte Läuferscheibe auf einer geometrischen Bahn gehalten wird.

Beim Einseitenschleifen wird die Halbleiterscheibe rückseitig auf einer Unterlage ("chuck") gehalten und vorderseitig von einer Topfschleifscheibe unter Drehung von Unterlage und Schleifscheibe und langsamer axialer bzw. radialer Zustellung eingeebnet. Verfahren und Vorrichtungen zum einseitigen Oberflächenschleifen einer Halbleiterscheibe sind beispielsweise aus der US 2008 021 40 94 A1 oder aus EP 0 955 126 A2 bekannt.

Aus der KR 2011 006 6282 A, die die Grundlage für den Oberbegriff des beigefügten Anspruchs 1 bildet, ist eine Schleifscheibe bekannt, die, um die Kühleffizienz zu verbessern, mit mindestens einem Kühlmittelzuführungsloch ausgestattet ist, so dass das Kühlmittel direkt zu einem Schleifwerkzeug geleitet werden kann.

Beim simultanen Doppelseitenschleifen ("(simultaneous)-double-disc grinding", sDDG) wird die Halbleiterscheibe frei schwimmend zwischen zwei, auf gegenüberliegenden kollinearen Spindeln montierten Schleifscheiben gleichzeitig beidseitig bearbeitet und dabei weitgehend frei von Zwangskräften axial zwischen einem vorder- und rückseitig wirkenden Wasser- (hydrostatisches Prinzip) oder Luftkissen (aerostatisches Prinzip) geführt und radial lose von einem umgebenden dünnen Führungsring oder von einzelnen radialen Speichen am Davonschwimmen gehindert. Verfahren und Vorrichtungen zum simultanen doppelseitigen Oberflächenschleifen einer Halbleiterscheibe sind beispielsweise aus EP 0 755 751 A1**,** EP 0 971 398 A1**,** DE 10 2004 011 996 A1 sowie DE 10 2006 032 455 A1 bekannt.

Allerdings verursacht das doppelseitige Schleifen von Halbleiterscheiben (DDG) kinematisch bedingt grundsätzlich einen höheren Materialabtrag im Zentrum der Halbleiterscheibe ("Schleifnabel"). Um nach dem Schleifen eine Halbleiterscheibe mit möglichst guter Geometrie zu erhalten, ist es notwendig, dass die beiden Schleifspindeln, auf denen die Schleifscheiben montiert werden, exakt kollinear ausgerichtet sind, da radiale und oder axiale Abweichungen einen negativen Einfluss auf die Form und Nanotopologie der geschliffenen Scheibe haben. Die deutsche Anmeldung DE 10 2007 049 810 A1 lehrt beispielsweise ein Verfahren zur Korrektur der Schleifspindelposition in Doppelseitenschleifmaschinen.

Bei den Schleifprozessen - dies betrifft sowohl einseitige als auch beidseitige Schleifverfahren- ist eine Kühlung des Schleifwerkzeuges und/oder der bearbeiteten Halbleiterscheibe erforderlich. Als Kühlmittel wird üblicherweise Wasser bzw. deionisiertes Wasser verwendet. Bei den Doppelseitenschleifmaschinen tritt das Kühlmittel üblicherweise aus dem Zentrum des Schleifwerkzeugs aus und wird mittels Zentrifugalkraft zu den Schleifzähnen, die kreisförmig am Außenrand der Schleifscheibe angeordnet sind, transportiert bzw. geschleudert. Der Kühlmitteldurchsatz, also die Menge an Kühlmittel, die innerhalb einer definierten Zeit austritt, kann elektronisch oder mechanisch geregelt werden.

Die Schrift DE 10 2007 030 958 A1 lehrt ein Verfahren zum Schleifen von Halbleiterscheiben, bei dem die Halbleiterscheiben einseitig oder beidseitig mittels wenigstens eines Schleifwerkzeugs, unter Zuführung eines Kühlmittels Material abtragend bearbeitet werden. Um eine konstante Kühlung während des Schleifens zu gewährleisten, wird der Kühlmittelfluss mit abnehmender Schleifzahnhöhe reduziert, da ein unverändert hoher Kühlmittelfluss andernfalls unvermeidlich zu Aquaplaning-Effekten führen würde.

Die Erfindung in der Schrift DE 10 2017 215 705 A1 basiert auf der optimalen Verteilung einer Flüssigkeit in einem Schleifwerkzeug zur gleichzeitig beidseitigen Material abtragenden Bearbeitung einer Halbleiterscheibe, die durch eine optimierte Schleuderplatte erzielt wird. Dabei wird gelehrt, dass sich eine ungleiche Verteilung der Flüssigkeit ungünstig auf das Schleifergebnis auswirkt.

Die Patentschrift US 2019/134782 A1 zeigt bestimmte Ausprägungen von Schleifscheiben, die für das Doppelseitenschleifen Verwendung finden können. Ferner wird die Verwendung von Wasser gelehrt, das mittels einer Düse von Innen auf die Schleifzähne der Schleifscheibe gebracht wird. Zusammen mit dem Schleifwasser spült es Schleifabrieb und Werkzeugabrieb aus dem Bearbeitungsbereich fort.

### Problembeschreibung

Alle genannten Schriften des Standes der Technik ist der Nachteil gemein, dass der Materialabtrag im Zentrum der Halbleiterscheiben höher ist als am Rand. Dadurch verschlechtern sich die Geometrieparameter der Halbleiterscheibe in diesem Bearbeitungsschritt. Diese Abweichung kann in den darauffolgenden Bearbeitungsschritten nicht oder nur ungenügend korrigiert werden. Die Qualität der Geometrie, die mittels Schleifen erreicht werden kann, ist mit den Verfahren, die aus dem Stand der Technik bekannt sind, ungenügend.

### Beschreibung der Aufgabe

Aufgabe der vorliegenden Erfindung ist es, ein Verfahren bereitzustellen, das die eben genannten Nachteile nicht zeigt.

### Beschreibung der Lösung der Aufgabe

Die Aufgabe wird gelöst durch ein Verfahren zum Schleifen einer Halbleiterscheibe, wobei die Halbleiterscheibe mittels eines Schleifwerkzeugs enthaltend Schleifzähne mit einer Höhe h unter Zuführung eines Kühlmediums in einen Kontaktbereich zwischen der sich drehenden Halbleiterscheibe und dem Schleifwerkzeug Material abtragend bearbeitet werden, wobei zu jedem Zeitpunkt des Schleifens ein erster Kühlmittelfluss auf einen ersten Bereich auf einer Seite der Halbleiterscheibe mittels einer oder mehrerer Düsen aufgebracht wird, und wobei zu jedem Zeitpunkt des Schleifens ein zweiter Kühlmittelfluss auf einen zweiten Bereich auf der einen Seite der Halbleiterscheibe mittels einer oder mehrerer Düsen aufgebracht wird, dadurch gekennzeichnet, dass der erste Bereich begrenzt wird durch den rechten unteren Quadranten der Halbleiterscheibe und der zweite Bereich begrenzt wird durch den linken unteren Quadranten und der Quotient aus dem ersten Kühlmittelfluss und der Summe des ersten und zweiten Kühlmittelflusses nicht größer ist als 35% und nicht kleiner ist als 25%.

Bevorzugt ist es, wenn die Halbleiterscheibe einen Nenndurchmesser von 300 mm beträgt und die Summe der Kühlmittelflüsse nicht kleiner ist als **800 ml/min** und nicht größer ist als **1200 ml/min.**

Auch bevorzugt ist es, wenn gleichzeitig beide Seiten der Halbleiterscheibe materialabtragend bearbeitet werden.

Ebenso bevorzugt ist es, wenn die Summe der Kühlmittelflüsse mit abnehmender Höhe h reduziert wird.

Ganz besonders bevorzugt ist es, wenn der erste Bereich ein Kreisringsektor ist, der eine Kreisringbreite w, einen Mittelpunkt und einen äußeren Radius aufweist und begrenzt wird durch eine erste Gerade durch den Mittelpunkt, die zu der vertikalen Symmetrieachse der Halbleiterscheibe um den Winkel α geneigt ist und ferner begrenzt wird durch eine zweite Gerade durch den Mittelpunkt, die zu der vertikalen Symmetrieachse der Halbleiterscheibe um den Winkel β geneigt ist und der zweite Bereich hervorgeht aus der Spiegelung des ersten Bereiches an der vertikalen Symmetrieachse der Halbleiterscheibe, wobei der Mittelpunkt auf der vertikalen Symmetrieachse der Halbleiterscheibe liegt und nicht weniger als 75 mm vom Mittelpunkt der Halbeiterschiebe entfernt ist und der Winkel α nicht weniger beträgt als 25° und der Winkel β nicht weniger ist als 45°, und die Kreisringbreite w nicht weniger beträgt als 10 mm und nicht mehr beträgt als 25 mm und der äußere Radius nicht weniger beträgt als 80 mm und nicht mehr beträgt als 90 mm.

### Kurzbeschreibung der Figuren

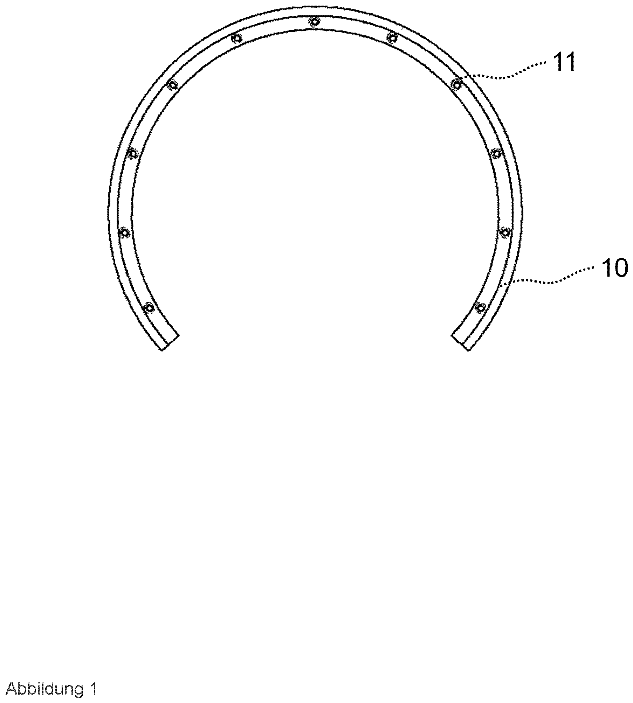

**Figur 1** zeigt beispielhaft eine Vorrichtung (**10**), die verwendet werden kann, um die benötigten Mengen an Kühlflüssigkeit während des Schleifvorgangs aufzubringen. Düsen (**11**) sind dabei so angebracht, dass sie Kühlflüssigkeit auf die zu schleifende Seite einer Halbleiterscheibe aufbringen können. Idealerweise können die Düsen dabei getrennt voneinander angesteuert werden, so dass jede Düse mit einem vorher definierten und eventuell zeitlich sich verändernden Durchfluss an Kühlflüssigkeit betrieben werden können.

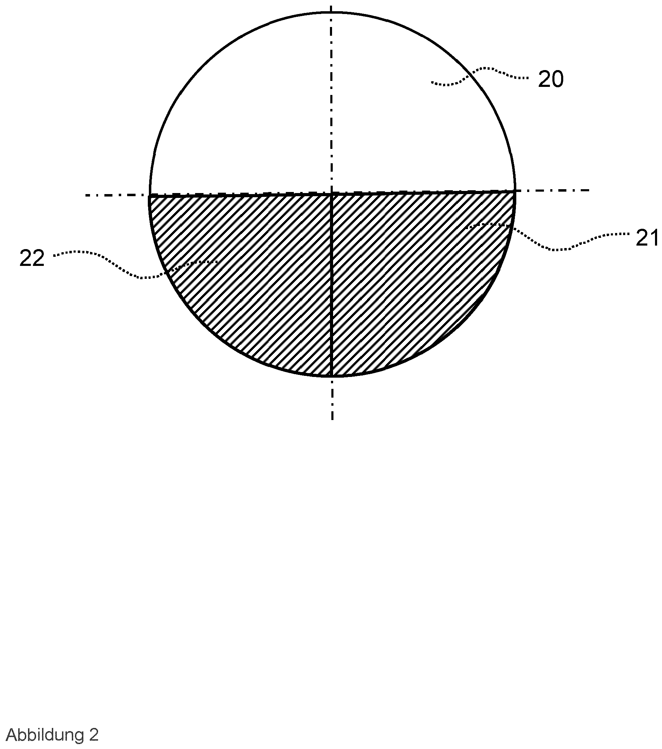

**Figur 2** zeigt zwei Bereiche auf der Halbleiterscheibe (**20**), die bevorzugt mit dem Kühlmittel beaufschlagt werden, um den vorteilhaften Effekt in der Geometrie zu erreichen. Es wird ein erster Bereich (**22**) gezeigt, der in dem linken unteren Quadranten der Hableiterscheibe liegt und ein zweiter Bereich (**21**), der in dem rechten unteren Quadranten der Halbleiterscheibe liegt.

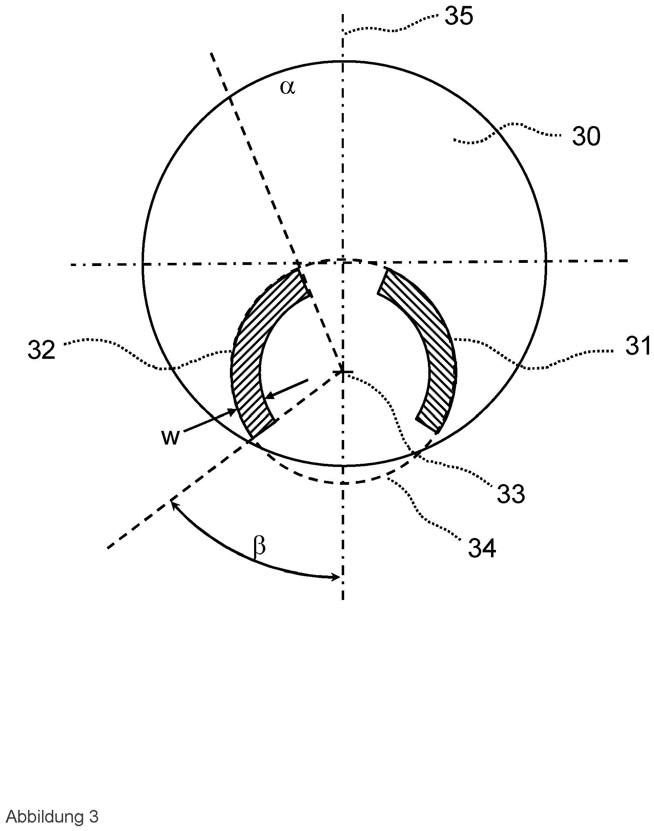

**Figur 3** zeigt zwei besonders bevorzugte Bereiche (schraffiert) auf einer Halbleiterscheibe (**30**), die mit dem Kühlmittel beaufschlagt werden, um die Geometrie sogar noch weiter zu verbessern. Der erste Bereich (**32**) ist ein Kreisringsektor, der eine Kreisringbreite **w,** einen Mittelpunkt (**33**) und einen äußeren Radius aufweist. Er wird begrenzt durch eine erste Gerade durch den Mittelpunkt (**33**), die zu der vertikalen Symmetrieachse (**35**) der Halbleiterscheibe (**30**) um den Winkel α geneigt ist. Ferner wird er begrenzt durch eine zweite Gerade durch den Mittelpunkt (**33**), die zu der vertikalen Symmetrieachse (**35**) der Halbleiterscheibe um den Winkel β geneigt ist. Zudem ist ein zweiter Bereich (**31**) gezeigt, der hervorgeht aus der Spieglung des ersten Bereiches (**32**) an der vertikalen Symmetrieachse der Halbleiterscheibe (**35**). Die Außengrenzen beider Bereiche liegen auf dem eingezeichneten Kreis (**34**).

Der Mittelpunkt (**33**) liegt auf der vertikalen Symmetrieachse (**35**) der Halbleiterscheibe (**30**) liegt gleichzeitig unterhalb der horizontalen Symmetrieachse der Halbleiterscheibe.

### Detaillierte Beschreibung erfindungsgemäßer Ausführungsbeispiele

Zur Beurteilung der Geometrie von Halbleiterscheiben gibt es viele genormte Messverfahren und Messmethoden. Die Erfinder beschränkten sich darauf die Halbleiterscheiben mittels der Parameter THA25 und Warp zu beurteilen.

zu **THA25:** Zur Untersuchung der Nanotopographie kann ein Interferometer, beispielsweise ein Gerät vom Typ WaferSight^{™} der KLA-Tencor Corp. verwendet werden. Ein solches Interferometer eignet sich zur Messung der Topographie auf der Oberseite einer Halbleiterscheibe. Das Gerät bildet eine Höhenkarte der Oberseite der Halbleiterscheibe ab, die gefiltert wird und über die ein Analysenfenster mit definierter Analysenfläche bewegt wird. Die Auswertung der Höhenunterschiede im Analysenfenster erfolgt durch THA ("threshold height analysis") entsprechend der Normen SEMI M43-0418 und SEMI M78-0618 festgelegten Verfahrensvorschriften.

Eine Warp-Messung kann beispielsweise nach SEMI MF 1390-0218 erfolgen.

Optimal eingestellte DDG-Maschinen ermöglichen es zwar, geschliffene Halbleiterscheiben mit verbesserten Shape, Bow, Warp sowie Nanotopographien zu erzeugen, es stellte sich jedoch heraus, dass die Qualität dieser Halbleiterscheiben nicht ausreicht.

Die Erfinder haben erkannt, dass durch eine gezielte Zugabe eines Kühlmittelflusses, die an definierten Bereichen der Halbleiterschiebe während des Schleifens erfolgt, eine Verbesserung der Geometrie der Halbleiterscheibe erreicht werden kann.

Ein Kristallstück mit einem Nenndurchmesser von 300 mm aus Silizium gewonnen aus einem Kristallstab, der mit der Czochralski Methode gezogen wurde, wurde mittels einer Drahtsäge in Halbleiterscheiben geschnitten.

Auf einer Schleifanlage vom Typ Koyo DSGX320 wurden die Halbleiterscheiben mit unterschiedlichen Bedingungen bezüglich des Kühlmittelflusses geschliffen. Die Schleifanlage war dabei bestückt mit einem kommerziell erhältlichen Schleifwerkzeug ("Grind Wheel") der Firma ALMT, Typ #3000-OVH.

Bei den Doppelseitenschleifmaschinen tritt das Prozesskühlmittel üblicherweise aus dem Zentrum des Schleifwerkzeuges aus und wird mittels der Zentrifugalkraft zu den Schleifzähnen transportiert. Der Kühlmitteldurchsatz lässt sich derart regeln, dass der Kühlmittelfluss auf einem Sollwert gehalten werden kann.

Gemäß dem Stand der Technik wird die Schleifwassermenge zahnhöhenabhängig (gemäß DE 10 2007 030 958 A1) geregelt dem Prozess zugeführt. Hierdurch wird sichergestellt, dass es weder zu einem Aquaplaning gleichen Aufschwimmen des Werkzeugs auf dem zu bearbeitenden Wafer kommt, wenn im Prozess zu viel Kühlmittel auf dem Weg vom Werkzeuginneren nach außen gepresst wird, bzw. es zu einer Schleifbrand gleichen Überhitzung des zu bearbeitenden Wafers sowie zu Versagen der Schleifscheibe kommt, wenn zu wenig Kühlmittel im Prozess zur Verfügung steht.

Die Erfinder haben erkannt, dass die Verteilung des Kühlmittels auf die Halbleiterscheibe einen erheblichen Einfluss auf das Ergebnis hat. In herkömmlichen Schleifanlagen wird zum Beispiel Kühlmittel über Fliehkräfte auf die zu schleifende Halbleiterscheibe verteilt, was offenbar nicht immer ausreichend ist, um eine gewünschte Qualität der Oberfläche (Ebenheit) zu erhalten.

Die Erfinder haben deshalb eine Vorrichtung entwickelt, mit deren Hilfe es möglich ist, über eine Vielzahl von Düsen Kühlmittel sowohl zeit- als auch ortsaufgelöst sowohl auf die Vorder- als auch auf die Rückseite der Halbleiterscheibe zu applizieren.

**Abbildung 1** zeigt schematisch Vorrichtung, die dafür geeignet ist, Kühlflüssigkeit auf einer Halbleiterscheibe während des Schleifens zu applizieren.

Den Erfindern gelang es das Verfahren zum Schleifen einer Halbleiterscheibe zu verbessern, indem sie die Halbleiterscheibe mittels eines Schleifwerkzeugs enthaltend Schleifzähne mit einer Höhe h unter Zuführung eines Kühlmediums in einen Kontaktbereich zwischen der sich drehenden Halbleiterscheibe und dem Schleifwerkzeug Material abtragend bearbeiteten. Zu jedem Zeitpunkt des Schleifens wurde ein erster Kühlmittelfluss auf einen ersten Bereich auf einer Seite der Halbleiterscheibe mittels einer oder mehrerer Düsen aufgebracht. Gleichzeitig wurde ein zweiter Kühlmittelfluss auf einen zweiten Bereich auf der einen Seite der Halbleiterscheibe mittels einer oder mehrerer Düsen aufgebracht.

Sie erkannten, dass es besonders bevorzugt ist, dass der erste Bereich begrenzt wird durch den rechten unteren Quadranten der Halbleiterscheibe und der zweite Bereich begrenzt wird durch den linken unteren Quadranten. Ferner erkannten die Erfinder, dass es erforderlich ist, dass der Quotient aus dem ersten Kühlmittelfluss und der Summe des ersten und zweiten Kühlmittelflusses nicht größer ist als 35% und nicht kleiner ist als 25%.

Bevorzugt rotiert die Halbleiterscheibe während des Schleifvorgangs. Die Rotation erfolgt dabei im Uhrzeigersinn, wobei die Rotation im Uhrzeigersinn so verstanden wird, dass der Kontaktbereich auf der Halbleiterscheibe betrachtet wird.

Der erste und der zweite Bereich sind in **Abbildung 2** graphisch dargestellt.

Besonders bevorzugt ist es, dass die Halbleiterscheibe einen Nenndurchmesser von 300 mm beträgt und die Summe der Kühlmittelflüsse nicht kleiner ist als 800 ml/min und nicht größer ist als 1200 ml/min.

Ganz besonders bevorzugt ist, wenn gleichzeitig beide Seiten der Halbleiterscheibe materialabtragend bearbeitet werden.

Bevorzugt ist auch, dass die Summe der Kühlmittelflüsse mit abnehmender Höhe h der Schleifzähne reduziert wird.

**Abbildung 3** zeigt die Bereiche, bei denen die Erfinder die besten Ergebnisse erzielt haben. Der erste Bereich ist dabei ein Kreisringsektor, der eine Kreisringbreite **w,** einen Mittelpunkt und einen äußeren Radius aufweist und begrenzt wird durch eine erste Gerade durch den Mittelpunkt, die zu der vertikalen Symmetrieachse der Halbleiterscheibe um den Winkel α geneigt ist und ferner begrenzt wird durch eine zweite Gerade durch den Mittelpunkt, die zu der vertikalen Symmetrieachse der Halbleiterscheibe um den Winkel β geneigt ist.

Der zweite Bereich geht dabei aus der Spieglung des ersten Bereiches an der vertikalen Symmetrieachse der Halbleiterscheibe hervor, wobei der Mittelpunkt auf der vertikalen Symmetrieachse der Halbleiterscheibe liegt und nicht weniger als 75 mm vom Mittelpunkt der Halbeiterschiebe entfernt ist.

Der besagte Winkel α beträgt dabei bevorzugt nicht weniger als 25° und der Winkel β nicht weniger ist als 45°, und die Kreisringbreite w beträgt bevorzugt nicht weniger als 10 mm und nicht mehr als 25 mm und der äußere Radius bevorzugt nicht weniger als 80 mm und nicht mehr als 90 mm.

Als Kühlmedium bevorzugt Wasser verwendet, es ist aber auch denkbar, dass zusätzlich Additive verwendet werden.

Durch die Zugabe des Kühlmediums hat sich gezeigt, dass die Geometrie des Wafers sich erheblich verbessert. Wird jedoch der Fluss des Kühlmediums während des Schleifvorganges unterbrochen, verschlechtert sich auch die Geometrie der Halbleiterscheibe wieder. Daher ist es unabdingbar, dass während des Schleifens der Fluss des Kühlmediums nicht unterbrochen wird.

## Patentansprüche

1. Verfahren zum Schleifen einer Halbleiterscheibe,
wobei die Halbleiterscheibe (20, 30) mittels eines Schleifwerkzeugs enthaltend Schleifzähne mit einer Höhe h unter Zuführung eines Kühlmediums in einen Kontaktbereich zwischen der sich drehenden Halbleiterscheibe und dem Schleifwerkzeug Material abtragend bearbeitet werden,
wobei zu jedem Zeitpunkt des Schleifens ein erster Kühlmittelfluss auf einen ersten Bereich auf einer Seite der Halbleiterscheibe mittels einer oder mehrerer Düsen (11) aufgebracht wird,
und wobei zu jedem Zeitpunkt des Schleifens ein zweiter Kühlmittelfluss auf einen zweiten Bereich auf der einen Seite der Halbleiterscheibe (20) mittels einer oder mehrerer Düsen (11) aufgebracht wird,
**dadurch gekennzeichnet, dass** der erste Bereich (22) begrenzt wird durch den rechten unteren Quadranten der Halbleiterscheibe und der zweite Bereich (21) begrenzt wird durch den linken unteren Quadranten und der Quotient aus dem ersten Kühlmittelfluss und der Summe des ersten und zweiten Kühlmittelflusses nicht größer ist als 35% und nicht kleiner ist als 25%.

2. Verfahren nach Anspruch 1, **dadurch gekennzeichnet, dass** die Halbleiterscheibe (20,30) einen Nenndurchmesser von 300 mm beträgt und die Summe der Kühlmittelflüsse nicht kleiner ist als **800 ml/min** und nicht größer ist als **1200 ml/min.**

3. Verfahren nach Anspruch 1, **dadurch gekennzeichnet, dass** gleichzeitig beide Seiten der Halbleiterscheibe (20, 30) materialabtragend bearbeitet werden.

4. Verfahren nach Anspruch 1, **dadurch gekennzeichnet, dass** die Halbleiterscheibe (20, 30) während des Schleifvorgangs rotiert und die Rotation im Uhrzeigersinn erfolgt, wobei der Kontaktbereich betrachtet wird.

5. Verfahren nach Anspruch 1, **dadurch gekennzeichnet, dass** die Summe der Kühlmittelflüsse mit abnehmender Höhe h reduziert wird.

6. Verfahren nach Anspruch 1, **dadurch gekennzeichnet, dass**
der erste Bereich ein Kreisringsektor ist,
der eine Kreisringbreite w, einen Mittelpunkt (33) und einen äußeren Radius aufweist
und begrenzt wird durch eine erste Gerade durch den Mittelpunkt (33), die zu der vertikalen Symmetrieachse (35) der Halbleiterscheibe (20, 30) um den Winkel α geneigt ist
und ferner begrenzt wird durch eine zweite Gerade durch den Mittelpunkt (33), die zu der vertikalen Symmetrieachse (35) der Halbleiterscheibe (20, 30) um den Winkel β geneigt ist und
der zweite Bereich (31) hervorgeht aus der Spieglung des ersten Bereiches (32) an der vertikalen Symmetrieachse der Halbleiterscheibe (20, 30), wobei der Mittelpunkt auf der vertikalen Symmetrieachse (35) der Halbleiterscheibe (20, 30) liegt und nicht weniger 75 mm vom Mittelpunkt der Halbeiterschiebe (20, 30) entfernt ist
und der Winkel α nicht weniger beträgt als 25°
und der Winkel β nicht weniger ist als 45°,
und die Kreisringbreite **w** nicht weniger beträgt als 10 mm und nicht mehr beträgt als 25 mm
und der äußere Radius nicht weniger beträgt als 80 mm und nicht mehr beträgt als 90 mm.

## Claims

1. Method for grinding a semiconductor wafer,
wherein the semiconductor wafer (20, 30) is machined so as to remove material by way of a grinding tool containing grinding teeth with a height h with a coolant being fed into a contact region between the rotating semiconductor wafer and the grinding tool,
wherein, at each point in time of the grinding, a first coolant flow is applied to a first region on one side of the semiconductor wafer by way of one or more nozzles (11),
and wherein, at each point in time of the grinding, a second coolant flow is applied to a second region on said one side of the semiconductor wafer (20) by way of one or more nozzles (11),
**characterized in that** the first region (22) is delimited by the lower right quadrant of the semiconductor wafer and the second region (21) is delimited by the lower left quadrant and the quotient of the first coolant flow and the sum of the first and second coolant flow is not greater than **35%** and not less than **25%.**

2. Method according to Claim 1, **characterized in that** the semiconductor wafer (20, 30) has a nominal diameter of 300 mm and the sum of the coolant flows is not less than **800 ml/min** and not greater than **1200 ml/min.**

3. Method according to Claim 1, **characterized in that** both sides of the semiconductor wafer (20, 30) are simultaneously machined so as to remove material.

4. Method according to Claim 1, **characterized in that** the semiconductor wafer (20, 30) is rotated during the grinding process and the rotation takes place in the clockwise direction considering the contact region.

5. Method according to Claim 1, **characterized in that** the sum of the coolant flows is reduced as the height h decreases.

6. Method according to Claim 1, **characterized in that** the first region is a circular ring sector that has a circular ring width w, a midpoint (33) and an external radius
and is delimited by a first straight line through the midpoint (33)
that is inclined with respect to the vertical axis of symmetry (35) of the semiconductor wafer (20, 30) by the angle α
and is furthermore delimited by a second straight line through the midpoint (33) that is inclined with respect to the vertical axis of symmetry (35) of the semiconductor wafer (20, 30) by the angle β and
the second region (31) arises from the mirror image of the first region (32) at the vertical axis of symmetry of the semiconductor wafer (20, 30),
wherein the midpoint lies on the vertical axis of symmetry (35) of the semiconductor wafer (20, 30) and is not less than 75 mm away from the midpoint of the semiconductor wafer (20, 30)
and the angle α is not less than 25°
and the angle β is not less than 45°
and the circular ring width w is not less than 10 mm and not more than 25 mm
and the external radius is not less than 80 mm and not more than 90 mm.

## Revendications

1. Procédé de rectification d'une galette en semiconducteur,
la galette en semiconducteur (20, 30) étant usinée avec enlèvement de matière au moyen d'un outil de rectification contenant des dents de rectification ayant une hauteur h en amenant un fluide de refroidissement dans une zone de contact entre la galette en semiconducteur en rotation et l'outil de rectification, à chaque instant de la rectification, un premier flux de fluide de refroidissement étant appliqué sur une première zone sur un côté de la galette en semiconducteur au moyen d'une ou de plusieurs buses (11),
et à chaque instant de la rectification, un deuxième flux de fluide de refroidissement étant appliqué sur une deuxième zone sur ledit côté de la galette en semiconducteur (20) au moyen d'une ou de plusieurs buses (11),
**caractérisé en ce que** la première zone (22) est délimitée par les quadrants inférieurs côté droit de la galette en semiconducteur et la deuxième zone (21) est délimitée par les quadrants inférieurs côté gauche de la galette en semiconducteur et le quotient du premier flux de fluide de refroidissement et de la somme des premier et deuxième flux de fluide de refroidissement n'est pas supérieur à 35 % et pas inférieur à 25 %.

2. Procédé selon la revendication 1, **caractérisé en ce que** la galette en semiconducteur (20, 30) possède un diamètre nominal de 300 mm et la somme des flux de fluide de refroidissement n'est pas inférieure à 800 ml/min et pas supérieure à 1200 ml/min.

3. Procédé selon la revendication 1, **caractérisé en ce que** les deux côtés de la galette en semiconducteur (20, 30) sont usinés simultanément avec enlèvement de matière.

4. Procédé selon la revendication 1, **caractérisé en ce que** la galette en semiconducteur (20, 30) effectue une rotation pendant l'opération de rectification et la rotation s'effectue dans le sens des aiguilles d'une montre, la zone de contact étant prise en considération.

5. Procédé selon la revendication 1, **caractérisé en ce que** la somme des flux de fluide de refroidissement est réduite à mesure que la hauteur h diminue.

6. Procédé selon la revendication 1, **caractérisé en ce que** la première zone est un secteur en anneau circulaire, lequel présente une largeur d'anneau circulaire w, un centre (33) et un rayon extérieur,
et est délimitée par une première droite à travers le centre (33),
laquelle est inclinée de l'angle α par rapport à l'axe de symétrie vertical (35) de la galette en semiconducteur (20, 30),
et est en outre délimitée par une deuxième droite à travers le centre (33), laquelle est inclinée de l'angle β par rapport à l'axe de symétrie vertical (35) de la galette en semiconducteur (20, 30) et
la deuxième zone (31) est issue de la réflexion de la première zone (32) au niveau de l'axe de symétrie vertical de la galette en semiconducteur (20, 30),
le centre se trouvant sur l'axe de symétrie vertical (35) de la galette en semiconducteur (20, 30) et n'étant pas éloigné de moins de 75 mm du centre de la galette en semiconducteur (20, 30)
et l'angle α ne se montant pas à moins de 25°
et l'angle β n'étant pas inférieur à 45°,
et la largeur d'anneau circulaire w ne se montant pas à moins de 10 mm et ne se montant pas à plus de 25 mm et le rayon extérieur ne se montant pas à moins de 80 mm et ne se montant pas à plus de 90 mm.
